# EUROPEAN PATENT APPLICATION

(11) **EP 4 811 935 A1**
(43) Date of publication of application: **23.09.2026**
(21) Application number: 26162156.9
(22) Date of filing: 04.03.2026
(51) Int. Cl.: H05K 1/11, H05K 1/181, H05K 3/341

(54) **METHOD FOR SHRINKING MEMORY SIGNAL VIA REGION IN ACCORDANCE WITH PREDETERMINED MEMORY-SIDE BALL LAYOUT TO ADJUST CONTROL-SIDE BALL ARRANGEMENT FOR INSTALLING CONTROL CIRCUIT AT PRINTED CIRCUIT BOARD, AND ASSOCIATED APPARATUS**

(30) Priority: 20.03.2025 TW 114110529
(71) Applicant: Realtek Semiconductor Corp., HsinChu 30076 (TW)
(72) Inventor: Lai, Chao-Min, 30076 HsinChu (TW); Yen, Shou-Te, 30076 HsinChu (TW)
(74) Representative: Straus, Alexander

(57) **Abstract**

A method for shrinking a memory signal via region in accordance with memory-side ball layout to adjust control-side ball arrangement for installing a control circuit at a printed circuit board (PCB) and associated apparatus are provided. The method may include: providing a set of pads on a board-side region of a package of the control circuit, the set of pads corresponding to a set of first pads within a first installation region of the PCB, to act as control-side memory signal pads for conducting a set of predetermined memory signals (S11); and providing multiple other pads on the board-side region, the multiple other pads corresponding to a set of remaining pads within the first installation region, to act as other-purpose pads for conducting other signals, where multiple vias are arranged as being adjacent to the first pads to shrink the memory signal via region, for enhancing control-side ball-arrangement flexibility (S12).

## Description

### Field of the Invention

The present invention relates to circuit design, and more particularly, to a method for shrinking a memory signal via region in accordance with predetermined memory-side ball layout to adjust control-side ball arrangement for installing a control circuit at a printed circuit board (PCB), and to associated apparatus such as the control circuit and the PCB.

### Background of the Invention

According to the related art, a memory package conforming to the Low-Power Double Data Rate (LPDDR) standards such as the LPDDR4 standard may be coupled to a printed circuit board (PCB) through multiple solder balls (or "balls") in an old configuration. An existing circuit layout control scheme has been proposed to solve some problems in the related art. However, some additional problems may arise. When a new version of the LPDDR standards becomes available, a memory package compliant with the LPDDR standards such as the LPDDR5/LPDDR5X standards may be coupled to a PCB through (15 * 21) balls in a certain configuration, in which the ball pitches such as the pitch along the X-axis and the pitch along the Y-axis may be predetermined lengths, respectively. Due to the substantial increase in the number of balls and associated area of an LPDDR5 die/chip, adopting the existing circuit layout control scheme would significantly increase the package size of a system-on-chip (SoC). Accordingly, there is a need for a novel method and associated architecture for solving these problems with fewer side effects.

### Summary of the Invention

It is an objective of the present invention to provide a method for shrinking a memory signal via region in accordance with predetermined memory-side ball layout to adjust control-side ball arrangement for installing a control circuit at a PCB, and associated apparatus such as the control circuit and the PCB, in order to solve the problems in the related art. A method according to the invention is defined in the independent claim. The dependent claims define preferred embodiments thereof.

At least one embodiment of the present invention provides a method for shrinking a memory signal via region in accordance with predetermined memory-side ball layout to adjust control-side ball arrangement for installing a control circuit at a PCB, where the PCB has a first installation region and a second installation region for installing the control circuit and a memory, respectively, the first installation region and the second installation region are located on two sides (e.g., opposite sides) of the PCB, and the two sides comprise a first side and a second side that are opposite to each other. The method may comprise: providing (or fabricating) a set of pads on a board-side region of a package of the control circuit, the set of pads corresponding to a set of first pads within the first installation region, to act as control-side memory signal pads for conducting a set of predetermined memory signals; and providing (or fabricating) multiple other pads on the board-side region of the package of the control circuit, the multiple other pads corresponding to a set of remaining pads within the first installation region, to act as other-purpose pads for conducting other signals, wherein a set of second pads within the second installation region are distributed both inside and outside the memory signal via region, multiple vias on the PCB for conducting the set of predetermined memory signals extend through the two sides of the PCB to allow the set of predetermined memory signals to be transmitted between the control circuit and the memory by the set of first pads, the multiple vias, and the set of second pads, and the multiple vias are arranged as being adjacent to the set of first pads to shrink (or reduce, in size) the memory signal via region, for freeing space for the multiple other pads to enhance flexibility of the control-side ball arrangement.

At least one embodiment of the present invention provides a control circuit whose package is implemented according to the above method, wherein the package of the control circuit may comprise: the set of first pads, positioned within a first sub-region of the board-side region, configured to act as the aforementioned control-side memory signal pads, wherein the first sub-region of the board-side region is used as a first ball arrangement range of the aforementioned control-side memory signal pads on the board-side region; and the multiple other pads, positioned within a second sub-region of the board-side region, configured to act as the aforementioned other-purpose pads, wherein the second sub-region does not overlap with the first sub-region.

At least one embodiment of the present invention provides a PCB whose multiple pads are implemented according to the above method, wherein the multiple pads of the PCB comprise: the set of first pads, positioned within a first sub-region of the first installation region, the first sub-region of the first installation region corresponding to the first ball arrangement range of the aforementioned control-side memory signal pads on the board-side region; and the set of remaining pads, positioned within a second sub-region of the first installation region, wherein the second sub-region of the first installation region does not overlap with the first sub-region of the first installation region.

One of the advantages of the present invention is that, through proper design, the method, the control circuit, and the PCB of the present invention can minimize the package size/area of the control circuit without significantly increasing the associated costs such as material costs (e.g., SoC/PCB costs). For example, the control circuit may be an SoC, the memory may be a random-access memory (RAM), and the PCB may be arranged to install (e.g., mount) the control circuit such as the SoC and the memory/RAM such as an LPDDR 5 or above RAM. In addition, the method, the control circuit, and the PCB of the present invention can solve the problems in the related art with fewer side effects.

### Brief Description of the Drawings

In the following, the invention is further illustrated by way of example, taking reference to the accompanying drawings. Thereof
FIG. 1 is a schematic diagram of an electronic device according to an embodiment of the present invention, where the electronic device is implemented based on a method for shrinking a memory signal via region in accordance with predetermined memory-side ball layout to adjust control-side ball arrangement for installing a control circuit at a PCB,
FIG. 2 illustrates, in the lower half part thereof, a cross-region circuit layout control scheme of the method according to an embodiment of the present invention, where an intra-region circuit layout control scheme is illustrated in the upper half part of FIG. 2 for better comprehension,
FIG. 3 illustrates a top layer involved with a circuit architecture control scheme of the method according to an embodiment of the present invention,
FIG. 4 illustrates a second layer involved with the circuit architecture control scheme,
FIG. 5 illustrates a third layer involved with the circuit architecture control scheme,
FIG. 6 illustrates a bottom layer involved with the circuit architecture control scheme,
FIG. 7 illustrates grid lines, a memory signal pad region, and a memory signal via region involved with the circuit architecture control scheme,
FIG. 8 illustrates control-side pads involved with the circuit architecture control scheme according to an embodiment of the present invention,
FIG. 9 illustrates memory-side pads involved with the circuit architecture control scheme according to an embodiment of the present invention, and
FIG. 10 illustrates a flowchart of the method according to an embodiment of the present invention.

### Detailed Description

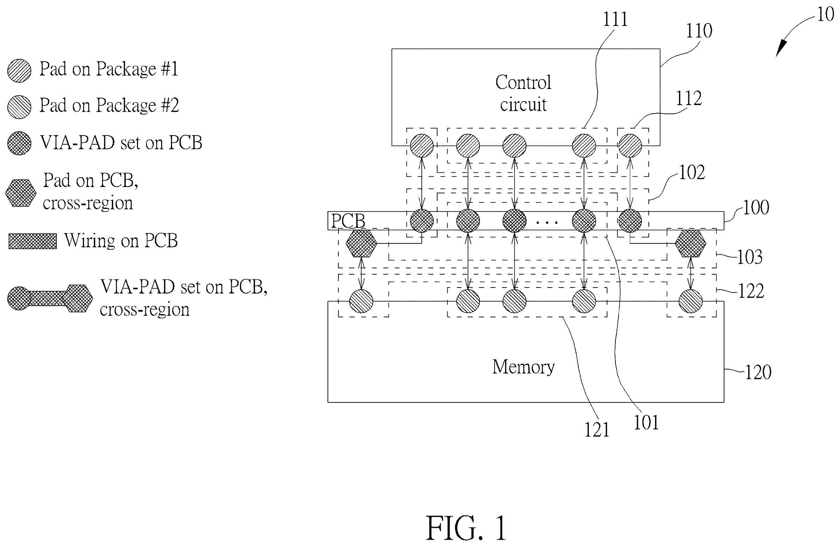

FIG. 1 is a schematic diagram of an electronic device 10 according to one embodiment of the present invention, where the electronic device 10 is implemented based on a method for shrinking a memory signal via region in accordance with predetermined memory-side ball layout to adjust control-side ball arrangement for installing a control circuit 110 at a PCB100. For better comprehension, the control-side and the memory-side packages may be referred to as Package #1 and Package #2, respectively. As shown in FIG. 1, the electronic device 10 may comprise the control circuit 110, a memory 120 (e.g., a RAM), and the PCB 100 configured to install the control circuit 110 and the memory 120. The control circuit 110 may control operations of the electronic device 10, while the memory 120 may store information for the electronic device 10 (or for the control circuit 110). In addition, the PCB 100 may comprise multiple via-pad sets (referred to as "VIA-PAD sets" hereinafter), each VIA-PAD set comprising a via and at least one pad. For example, the VIA-PAD sets may comprise VIA-PAD sets 101 and 102 for coupling the pads 111 and 112 of the control circuit 110 (or Package #1 thereof) and the pads 121 and 122 of the memory 120 (or Package #2 thereof) with each other. The PCB 100 may further comprise cross-region pads such as the pads 103, which may be coupled to the VIA-PAD sets 102 through traces on the PCB 100 to form larger VIA-PAD sets, such as cross-region VIA-PAD sets.

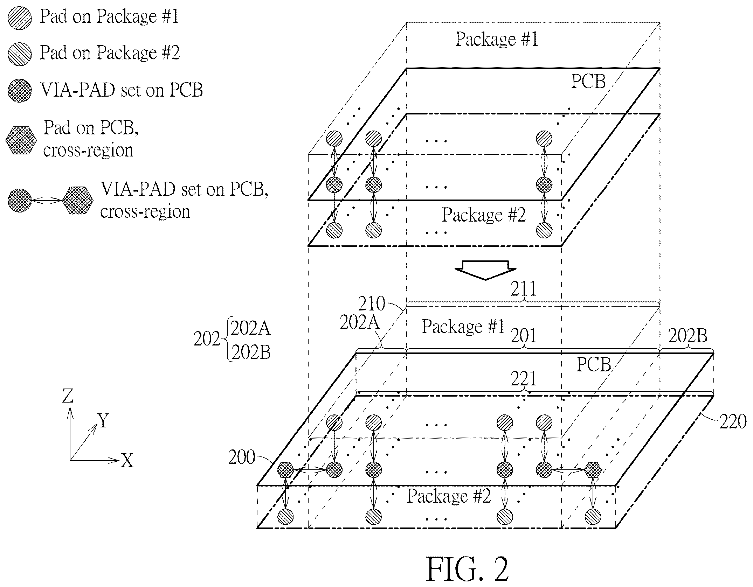

FIG. 2 illustrates, in the lower half part thereof, a cross-region circuit layout control scheme of the method according to an embodiment of the present invention, where an intra-region circuit layout control scheme is illustrated in the upper half part of FIG. 2 for better comprehension. Regarding a memory package conforming to the LPDDR4 standard, the intra-region circuit layout control scheme can be applied to the associated architecture of the LPDDR4 standard. As shown in the upper half part of FIG. 2, the pads/balls on an SoC (or Package #1 thereof) for coupling to an LPDDR4 memory, and the associated VIA-PAD sets on a PCB, may be implemented to correspond to the pads/balls on the LPDDR4 memory (or Package #2 thereof), for example, in a mirrored manner, to allow the SoC and the LPDDR4 memory to be installed respectively on the top layer and the bottom layer of the PCB, with substantial overlap in area to reduce the layout footprint. However, since the number of balls and the associated area of LPDDR5 memory increase significantly, adopting the intra-region circuit layout control scheme would greatly increase the package size of the SoC.

**Table 1**

| | | | | | | | | | | | | |
|---|---|---|---|---|---|---|---|---|---|---|---|---|
| A1 | ... | H1 | J1 | ... | N1 | P1 | R1 | T1 | ... | W1 | Y1 | AA1 |
| A2 | ... | H2 | J2 | ... | N2 | P2 | R2 | T2 | ... | W2 | Y2 | AA2 |
| ... | ... | ... | ... | ... | ... | ... | ... | ... | ... | ... | ... | ... |
| A15 | ... | H15 | J15 | ... | N15 | P15 | R15 | T15 | ... | W15 | Y15 | AA15 |

Table 1 illustrates multiple pads/balls in the predetermined memory-side (or memory package) ball layout, where taking an LPDDR5 layout as an example, there may be (21 * 15) = 315 balls {{A1, B1, ..., H1, J1, ..., N1, P1, R1, T1, ..., W1, Y1, AA1}, {A2, B2, ..., H2, J2, ..., N2, P2, R2, T2, ..., W2, Y2, AA2}, ..., {A15, B15, ..., H15, J15, ..., N15, P15, R15, T15, ..., W15, Y15, AA15}}, which may be arranged on a plane parallel to the X-Y plane defined by the X-axis and Y-axis, but the present invention is not limited thereto. Although adopting a Package #2 conforming to the LPDDR5 standard results in a significant increase in the area of Package #2, the cross-region circuit layout control scheme can reduce the memory signal via region to be smaller than the area of Package #2, thereby achieving an extremely compact configuration, and more particularly, concentrate the vias in the associated VIA-PAD sets (together with most pads coupled to these vias) within the memory signal via region such as a predetermined via concentration region 201, and provide/fabricate the cross-region pads corresponding to the outer peripheral pads of Package #2 in at least one peripheral region 202 such as the peripheral regions 202A and 202B, thereby forming the cross-region VIA-PAD sets. For better comprehension, the predetermined via concentration region 201 in FIG. 2 may be depicted as corresponding to a board-side region 211 of Package #1 of the control circuit 110, and being smaller in the X-axis direction (i.e., the direction of the X-axis) than a board-side region 221 of Package #2 of the memory 120. This is for illustrative purposes only and is not meant to be a limitation of the present invention. The predetermined via concentration region 201 may be depicted as partially overlapping with the board-side region 211, and being smaller than the board-side region 221 in both the X-axis and Y-axis directions (i.e., the respective directions of the X-axis and Y-axis).

When the ball layout of the package 220 (labeled "Package #2" for brevity) of the memory 120 has been determined, the cross-region circuit layout control scheme can minimize the size/area of the package 210 (labeled "Package #1" for brevity) of the control circuit 110 without significantly increasing the associated costs such as material costs (e.g., SoC/PCB costs). For example, the control circuit 110 may be a SoC, the memory 120 may be a RAM, and the PCB 100 (e.g., the PCB 200) may be arranged to install the control circuit 110 such as this SoC and the memory 120 such as an LPDDR 5 or above RAM.

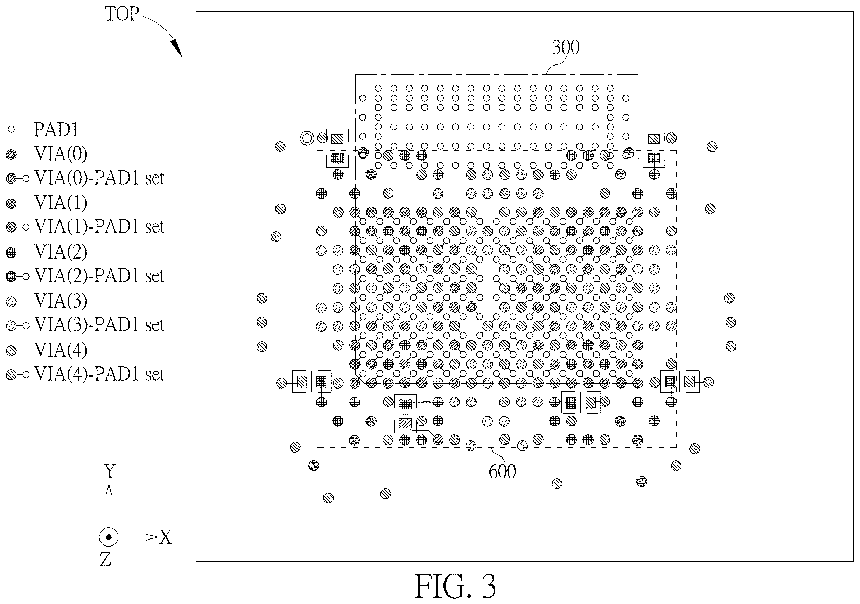

FIG. 3 to FIG. 6 respectively illustrate a top layer, a second layer, a third layer, and a bottom layer, such as four layers TOP, L2, L3, and BOTTOM in multiple layers of circuit (referred to as "multi-layer circuit" hereinafter), involved with a circuit architecture control scheme of the method according to an embodiment of the present invention, where three remaining layers in the multi-layer circuit (i.e., isolation layers positioned between the top layer, the second layer, the third layer, and the bottom layer) may be arranged to isolate the aforementioned four layers TOP, L2, L3, and BOTTOM. The PCB 100 (e.g., the PCB 200) may comprise a multi-layer circuit architecture, which may comprise the aforementioned multi-layer circuit, and more particularly, the aforementioned four layers TOP, L2, L3, and BOTTOM therein. According to some embodiments, the multi-layer circuit architecture may comprise more layers of circuit.

The PCB 100 such as PCB 200 may have a first installation region and a second installation region (respectively located on two sides or opposite sides of the PCB, the two sides comprising a first side and a second side which are opposite to each other, such as the installation regions 300 and 600, for installing the control circuit 110 and the memory 120, respectively. The board-side region 211 of Package #1 of the control circuit 110 corresponds to the first installation region such as the installation region 300, particularly having the same size and shape as the installation region 300, and facing the installation region 300 when the control circuit 110 is installed thereon. The board-side region 221 of Package #2 of the memory 120 corresponds to the second installation region such as the installation region 600, particularly having the same size and shape as the installation region 600, and facing the installation region 600 when the memory 120 is installed thereon. The associated operations of the method may comprise:
(1) providing/fabricating a set of pads {PAD0} on the board-side region 211 of Package #1 of the control circuit 110, the set of pads {PAD0} corresponding to a set of first pads {PAD1} within the first installation region such as the installation region 300, to act as control-side memory signal pads {PAD_{M}} for conducting a set of predetermined memory signals; and
(2) providing/fabricating multiple other pads {PAD0_{Other}} on the board-side region 211 of Package #1 of the control circuit 110, the multiple other pads {PAD0_{Other}} corresponding to a set of remaining pads {PAD1_{Other}} within the first installation region such as the installation region 300, to act as other-purpose pads for conducting other signals;
where a set of second pads {PAD2} within the second installation region such as the installation region 600 may be distributed both inside and outside the memory signal via region.

As shown in FIG. 3 to FIG. 6, multiple vias {VIA} on the PCB 100 such as the PCB 200 for conducting the set of predetermined memory signals may comprise respective sets of vias {VIA(0)}, {VIA(1)}, {VIA(2)}, {VIA(3)}, and {VIA(4)} corresponding to different signals or voltage levels for being used by the different signals/voltage levels, respectively, the VIA-PAD sets in the top layer such as the layer TOP may comprise various VIA-PAD1 sets such as VIA(0)-PAD1, VIA(1)-PAD1, VIA(2)-PAD1, VIA(3)-PAD1, and VIA(4)-PAD1 sets respectively corresponding to the vias VIA(0), VIA(1), VIA(2), VIA(3), and VIA(4), and the VIA-PAD sets in the bottom layer such as the layer BOTTOM may comprise various VIA-PAD2 sets such as VIA(0)-PAD2, VIA(1)-PAD2, VIA(2)-PAD2, VIA(3)-PAD2, and VIA(4)-PAD2 sets respectively corresponding to vias the VIA(0), VIA(1), VIA(2), VIA(3), and VIA(4). Furthermore, the multiple vias {VIA} such as the vias {VIA(0)}, {VIA(1)}, {VIA(2)}, {VIA(3)}, and {VIA(4)} may extend through the two sides of the PCB 100 (e.g., the PCB 200) to allow the set of predetermined memory signals to be transmitted between the control circuit 110 and the memory 120 by the set of first pads {PAD1}, the multiple vias {VIA}, and the set of second pads {PAD2}, and the multiple vias {VIA} may be arranged as being adjacent to the set of first pads {PAD1 } to shrink (or reduce the size of) the memory signal via region, for freeing space for the multiple other pads {PAD0_{Other}} to enhance the flexibility of the control-side ball arrangement.

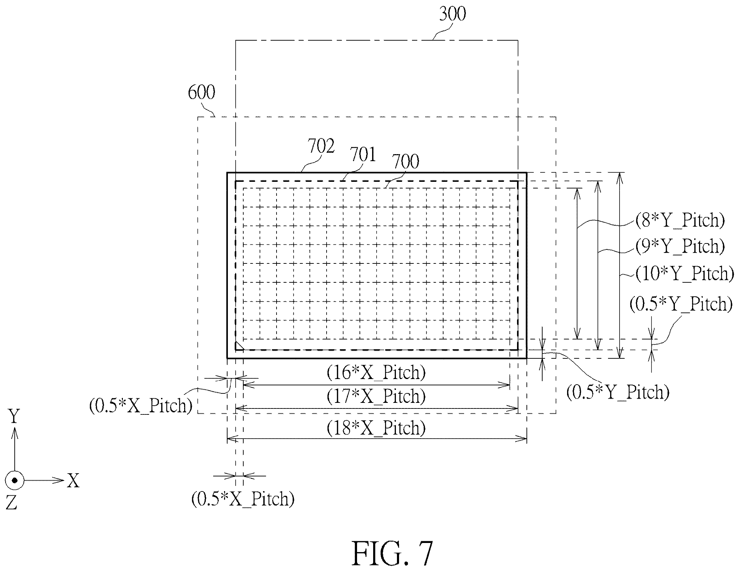

FIG. 7 illustrates grid lines 700, a memory signal pad region 701, and a memory signal via region 702 involved with the circuit architecture control scheme, where the grid lines 700 may represent the grid lines formed by the respective centers of the set of first pads {PAD1}, the memory signal pad region 701 may represent the region occupied by the set of first pads {PAD1}, and the memory signal via region 702 may represent the region occupied by the multiple vias {VIA}, and may be taken as an example of the memory signal via region mentioned above. A first pitch of the set of first pads {PAD1} along a first predetermined direction (e.g., the direction of a certain axis among the X-axis and Y-axis) on the first installation region such as the installation region 300 is equal to a first predetermined length, a second pitch of the set of first pads {PAD1} along a second predetermined direction (e.g., the direction of the other axis among the X-axis and Y-axis) on the first installation region such as the installation region 300 is equal to a second predetermined length, and the size of a first ball arrangement range of the control-side memory signal pads {PAD_{M}} on the board-side region 211 such as the board-side region 800 is equal to a first predetermined multiple of the first pitch multiplied by a second predetermined multiple of the second pitch. More particularly, the first predetermined direction and the second predetermined direction may represent the X-axis direction (i.e., the direction of the X-axis) and the Y-axis direction (i.e., the direction of the Y-axis), respectively, and the first pitch and the second pitch may represent an X-pitch such as the pitch X_Pitch and a Y-pitch such as the pitch Y_Pitch, respectively. Assuming that the first predetermined multiple and the second predetermined multiple are denoted as MULTIPLE1 and MULTIPLE2, respectively, the size of the first ball arrangement range is equal to (MULTIPLE1 * X_Pitch) * (MULTIPLE2 * Y_Pitch). For example, the first predetermined length may be any predetermined value within a range below 0.7 millimeters (mm) and greater than zero, and the second predetermined length may be any predetermined value within a range below 0.6 mm and greater than zero, but the present invention is not limited thereto. In other examples, the respective ranges of the first predetermined length and the second predetermined length may vary.

Further, the multiple vias {VIA} may be arranged to be interleaved with the set of first pads {PAD1} along at least one third predetermined direction (e.g., the respective directions of the vectors (+1, +1) and (+1, -1), measured in units of the pitches X_Pitch and Y_Pitch along the X-axis direction and the Y-axis direction, respectively), to shrink/reduce the memory signal via region 702. The size of the memory signal via region 702 may be equal to a third predetermined multiple of the first pitch multiplied by a fourth predetermined multiple of the second pitch. In particular, the third predetermined multiple may be greater than or equal to the first predetermined multiple plus one, and the fourth predetermined multiple may be greater than or equal to the second predetermined multiple plus one. Assuming that the third predetermined multiple and the fourth predetermined multiple are denoted as MULTIPLE3 and MULTIPLE4, respectively, the above relationships may be expressed as: MULTIPLE3 ≥ MULTIPLE1 + 1, and MULTIPLE4 ≥ MULTIPLE2 + 1. For example, when MULTIPLE 1 = 17 and MULTIPLE2 = 9, then MULTIPLE3 ≥ (17 + 1) = 18 and MULTIPLE4 ≥ (9 + 1) = 10. In the case of the tightest or relatively tight arrangement, the third predetermined multiple equals the first predetermined multiple plus one, and the fourth predetermined multiple equals the second predetermined multiple plus one. For example, when MULTIPLE1 = 17 and MULTIPLE2 = 9, then MULTIPLE3 = 18 and MULTIPLE4 = 10.

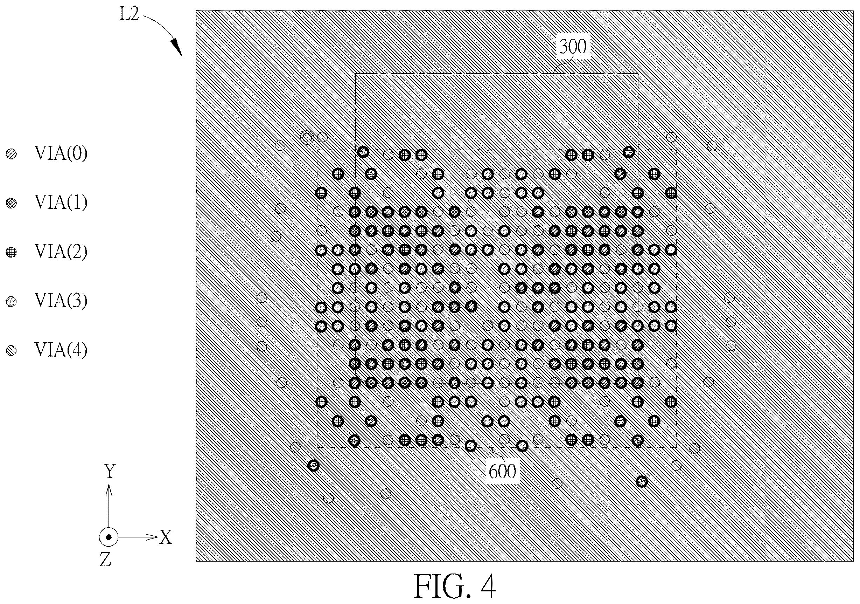

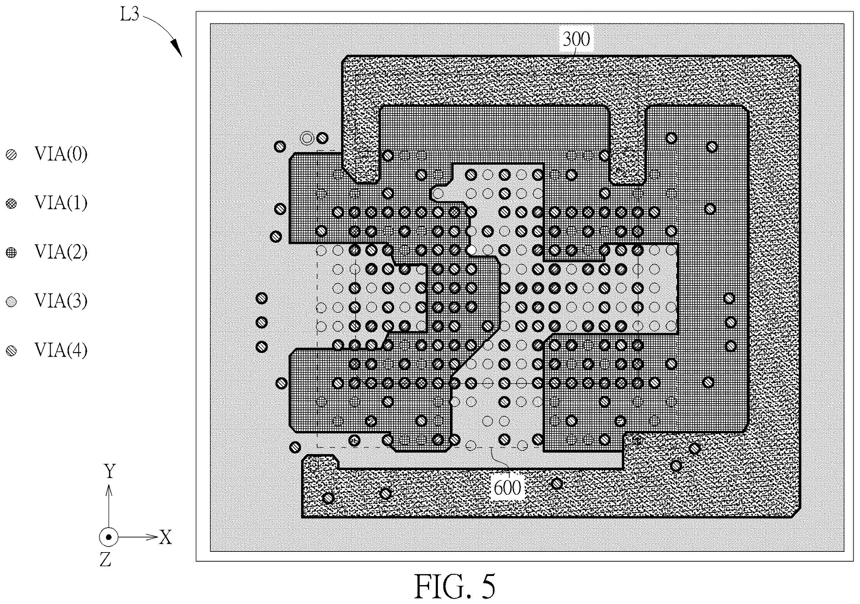

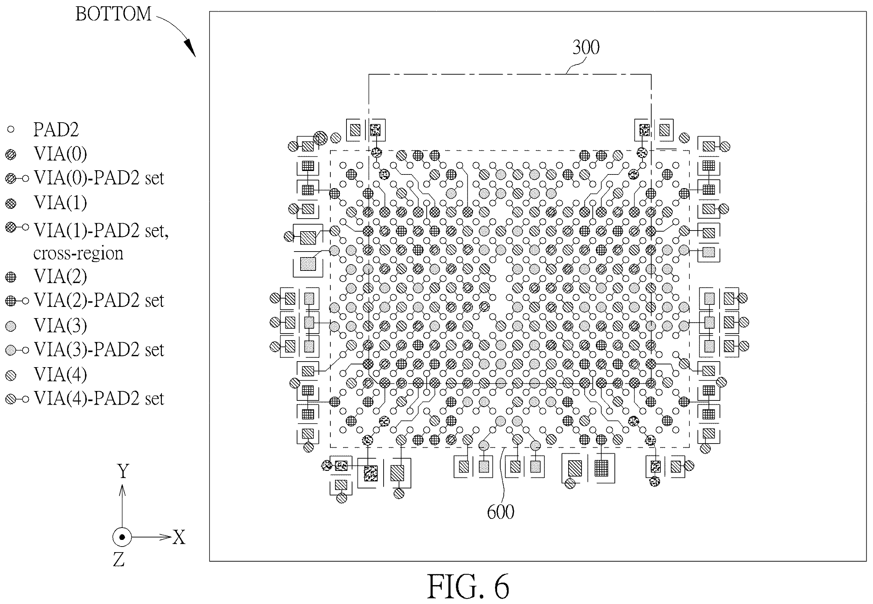

Referring to FIG. 3 to FIG. 7, it can be seen that the vias {VIA} near the boundary of the memory signal via region 702 among the multiple vias {VIA} are arranged to surround the grid lines 700 formed by the respective centers of the set of first pads {PAD1}. Regarding the memory signal via region 702:
(1) various VIA-PAD sets corresponding to the vias VIA(0), VIA(2), VIA(3), and VIA(4), such as the VIA(i)-PAD1 sets and the VIA(i)-PAD2 sets in which i ≠ 1, may be regarded as intra-region VIA-PAD sets, where the VIA(1)-PAD1-PAD2 sets (or "VIA(i)-PAD1/2 sets") corresponding to the vias VIA(0), VIA(2), VIA(3), and VIA(4) may be taken as examples of the VIA-PAD sets 101;
(2) the VIA(1)-PAD1 sets corresponding to the via VIA(1) may also be regarded as intra-region VIA-PAD sets, and may be taken as examples of the VIA-PAD sets 102; and
(3) the VIA(1)-PAD2 sets corresponding to the via VIA(1) may be regarded as cross-region VIA-PAD sets, where the VIA(1)-PAD1-PAD2 sets (or "VIA(1)-PAD1/2 sets") corresponding to the via VIA(1) may also be regarded as cross-region VIA-PAD sets;
where the pads {PAD2} coupled to the via VIA(1) may be regarded as cross-region pads, and may be taken as an example of the pads 103. Regarding any memory signal(s) transmitted by the VIA(1)-PAD1/2 set(s), such as the memory signals on the outer pads {PAD3} (or the pads {PAD3} of the outer region) of the Package #2 of the memory 120 (e.g., the LPDDR 5 or above RAM), the method can control the signal path thereof to run a short section of PCB wiring/trace from the corresponding pad PAD2 to the center as shown in FIG. 6, and arrange the via VIA(1) to pass through the layers L3 and L2 as shown in FIG. 5 and FIG. 4, respectively, to reach the corresponding pad PAD1 as shown in FIG. 3. Thus, for all memory signals within the set of predetermined memory signals except for power and ground signals, the method can complete arranging the multiple vias {VIA} within the memory signal via region 702 (e.g., a region/area of (18 * X_Pitch) × (10 * Y_Pitch)), making the memory signal via region 702 be significantly smaller than the installation region 600 occupied by the LPDDR5 RAM's original ball layout (e.g., a region/area of (21 * X_Pitch) × (15 * Y_Pitch)), and making arrangement of the corresponding pads {PAD1} on the top layer such as the layer TOP and the corresponding pads {PAD0} on the board-side region 211 be completed within the memory signal pad region 701 (e.g., a region/area of (17 * X_Pitch) × (9 * Y_Pitch)).

Some implementation details regarding the cross-region/intra-region VIA-PAD sets may be further described as follows. Assume that the first pad PAD1 and the second pad PAD2 corresponding to (in particular, connected to) the via VIA(1) are denoted as the first pad PAD1(1) and the second pad PAD2(1), respectively, and the first pad PAD1 and the second pad PAD2 corresponding to (in particular, connected to) the via VIA(i ≠ 1) are denoted as the first pad PAD1(i) and the second pad PAD2(i), respectively, where i ≠ 1. Referring to FIG. 6 and FIG. 7, it can be seen that a first portion of second pads {PAD2(i)} among the set of second pads {PAD2} are positioned within/inside the memory signal via region 702, and a second portion of second pads {PAD2(1)} among the set of second pads {PAD2} are positioned outside the memory signal via region 702. The multiple vias {VIA} can extend through the two sides of the PCB 100 (e.g., PCB 200) to allow a portion of memory signals among the set of predetermined memory signals to be transmitted between the control circuit 110 and the memory 120, and between the inside and the outside of the memory signal via region 702, by the first pads {PAD1(1)} in the set of first pads {PAD1}, the vias {VIA(1)} in the multiple vias {VIA}, and the second portion of second pads {PAD2(1)} among the set of second pads {PAD2}, while allowing another portion of memory signals (in particular, most predetermined memory signals) among the set of predetermined memory signals to be transmitted between the control circuit 110 and the memory 120 and within/inside the memory signal via region 702 by the first pads {PAD1(i)} in the set of first pads {PAD1 }, the vias {VIA(i)} in the multiple vias {VIA}, and the first portion of second pads {PAD2(i)} among the set of second pads {PAD2}.

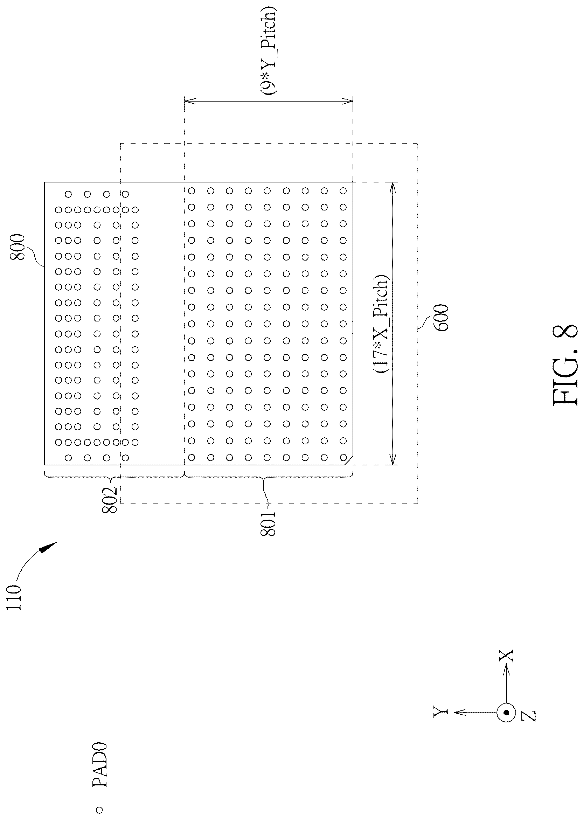

FIG. 8 illustrates the control-side pads involved with the circuit architecture control scheme according to an embodiment of the present invention, where these control-side pads may comprise the pads {PAD0} within the board-side region 211 such as the board-side region 800 (which may correspond to the aforementioned installation region 300). Package #1 of the control circuit 110 may comprise:
(1) the set of pads {PAD0}, such as the pads {PAD0} positioned within a first sub-region 801 of the board-side region 800, configured to act as the aforementioned control-side memory signal pads {PAD_{M}}, where the first sub-region 801 of the board-side region 800 is used as the first ball arrangement range; and
(2) the multiple other pads {PAD0_{Other}}, such as the pads {PAD0} positioned within a second sub-region 802 of the board-side region 800, configured to act as the aforementioned other-purpose pads, where the second sub-region 802 does not overlap with the first sub-region 801.

For brevity, similar descriptions for this embodiment are not repeated in detail here.

For better comprehension, multiple pads of/on the PCB 100 (e.g., PCB 200) may comprise:
(1) the set of first pads {PAD1}, positioned within a first sub-region of the first installation region such as the installation region 300 (for example, the sub-region occupied by the memory signal pad region 701 within the installation region 300 shown in FIG. 7, in particular, the sub-region below the upper boundary of the memory signal pad region 701), where the first sub-region of the installation region 300 corresponds to the first sub-region 801 of the board-side region 800, and also corresponds to the first ball arrangement range; and
(2) the set of remaining pads {PAD1_{Other}}, positioned within a second sub-region of the first installation region such as the installation region 300 (for example, the sub-region not occupied by the memory signal pad region 701 within the installation region 300 shown in FIG. 7, in particular, the sub-region above the upper boundary of the memory signal pad region 701), where the second sub-region of the installation region 300 does not overlap with the first sub-region of the installation region 300.

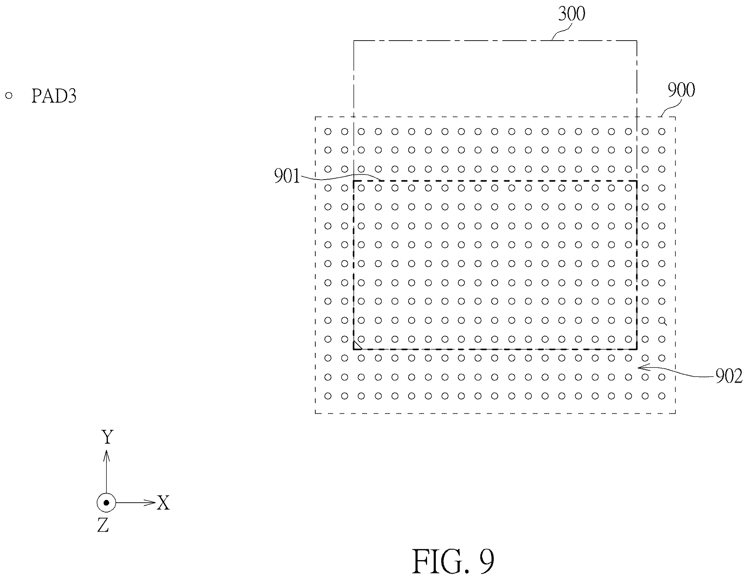

FIG. 9 illustrates the memory-side pads involved with the circuit architecture control scheme according to an embodiment of the present invention, where these memory-side pads may comprise the pads {PAD3} within the board-side region 221 such as the board-side region 900 (which may correspond to the aforementioned installation region 600). Taking the LPDDR5 layout as an example, Package #2 of the memory 120 may comprise (21 * 15) = 315 pads {PAD3} such as the pads/balls shown in Table 1, where the balls A1, AA1, A15, and AA15 are located at the upper-left corner, the upper-right corner, the lower-left corner, and the lower-right corner of the board-side region 900 shown in FIG. 9, respectively. A first sub-region 901 of the board-side region 900 corresponds to the memory signal pad region 701, while a second sub-region 902 of the board-side region 900 comprises the remaining region/area within board-side region 900. For brevity, similar descriptions for this embodiment are not repeated in detail here.

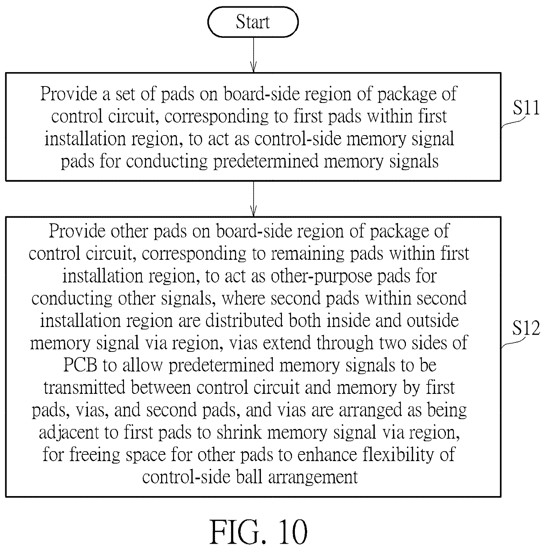

FIG. 10 illustrates a flowchart of the method according to an embodiment of the present invention. The control circuit 110 (or its Package #1 along with the pads thereon such as the pads 111 and 112) and the PCB 100 (or the pads thereon such as the pads in the VIA-PAD sets 101 and 102 as well as the pads 103) can be implemented in accordance with the method.

In Step S11, the pads 111 and 112 such as the set of pads {PAD0} are provided/fabricated on the board-side region 211 (e.g., the board-side area 800) of Package #1 of the control circuit 110, the set of pads {PAD0} corresponding to the set of first pads {PAD1} within the first installation region such as the installation region 300, to act as the control-side memory signal pads {PAD_{M}} for conducting the set of predetermined memory signals.

In Step S12, the multiple other pads {PAD0_{Other}} are provided/fabricated on the board-side region 211 (e.g., the board-side area 800) of Package #1 of the control circuit 110, the multiple other pads {PAD0_{Other}} corresponding to the set of remaining pads {PAD1_{Other}} within the first installation region such as the installation region 300, to act as the other-purpose pads for conducting the other signals, where the set of second pads {PAD2} within the second installation region such as the installation region 600 may be distributed both inside and outside the memory signal via region 702, the multiple vias {VIA} such as the vias {VIA(0)}, {VIA(1)}, {VIA(2)}, {VIA(3)}, and {VIA(4)} as mentioned above may extend through the two sides of the PCB 100 (e.g., the PCB 200) to allow the set of predetermined memory signals to be transmitted between the control circuit 110 and the memory 120 by the set of first pads {PAD1}, the multiple vias {VIA}, and the set of second pads {PAD2}, and the multiple vias {VIA} may be arranged as being adjacent to the set of first pads {PAD1} to shrink (or reduce, in size) the memory signal via region 702, for freeing space for the multiple other pads {PAD0_{Other}} to enhance the flexibility of the control-side ball arrangement. For brevity, similar descriptions for this embodiment are not repeated in detail here.

For better comprehension, the method may be illustrated with the working flow shown in FIG. 10. According to some embodiments, one or more steps may be added, deleted, or changed in the working flow shown in FIG. 10.

According to some control schemes, assuming that a High Density Interconnect (HDI) PCB is adopted, vias-on-pad/vias-in-pad can be arranged and coupled through inner-layer wiring/routing in order to couple the LPDDR5 RAM and the SoC. The method, the control circuit, and the PCB of the present invention can solve the problems in the related art with fewer side effects, while only requiring the use of a low-cost Plating Through Hole (PTH) PCB process.

## Claims

1. A method for shrinking a memory signal via region (702) in accordance with predetermined memory-side ball layout to adjust control-side ball arrangement for installing a control circuit (110) at a printed circuit board (PCB) (100, 200), the PCB (100, 200) having a first installation region (300) and a second installation region (600) for installing the control circuit (110) and a memory (120), respectively, the first installation region (300) and the second installation region (600) being located on two sides of the PCB (100, 200), the two sides comprising a first side and a second side which are opposite to each other, the method comprising:
providing a set of pads (111, 112, PAD0) on a board-side region (211, 800) of a package (#1) of the control circuit (110), the set of pads (111, 112, PAD0) corresponding to a set of first pads (PAD1) within the first installation region (300), to act as control-side memory signal pads for conducting a set of predetermined memory signals (S11); and
providing multiple other pads (PAD0) on the board-side region (211, 800) of the package (#1) of the control circuit (110), the multiple other pads (PAD0) corresponding to a set of remaining pads (PAD1) within the first installation region (300), to act as other-purpose pads for conducting other signals, wherein a set of second pads (PAD2) within the second installation region (600) are distributed both inside and outside the memory signal via region (702), multiple vias (VIA(0), VIA(1), VIA(2), VIA(3), VIA(4)) on the PCB (100, 200) for conducting the set of predetermined memory signals extend through the two sides of the PCB (100, 200) to allow the set of predetermined memory signals to be transmitted between the control circuit (110) and the memory (120) by the set of first pads (PAD1), the multiple vias (VIA(0), VIA(1), VIA(2), VIA(3), VIA(4)), and the set of second pads (PAD2), and the multiple vias (VIA(0), VIA(1), VIA(2), VIA(3), VIA(4)) are arranged as being adjacent to the set of first pads (PAD1) to shrink the memory signal via region (702), for freeing space for the multiple other pads (PAD0) to enhance flexibility of the control-side ball arrangement (S12).

2. The method of claim 1, wherein a first pitch of the set of first pads (PAD1) along a first predetermined direction on the first installation region (300) is equal to a first predetermined length, a second pitch of the set of first pads (PAD1) along a second predetermined direction on the first installation region (300) is equal to a second predetermined length, and a size of a first ball arrangement range of said control-side memory signal pads on the board-side region (211, 800) is equal to a first predetermined multiple of the first pitch multiplied by a second predetermined multiple of the second pitch.

3. The method of claim 2, wherein the first predetermined direction and the second predetermined direction represent an X-axis direction and a Y-axis direction, respectively, and the first pitch and the second pitch represent an X-pitch (X_Pitch) and a Y-pitch (Y_Pitch), respectively.

4. The method of claim 2, wherein the multiple vias (VIA(0), VIA(1), VIA(2), VIA(3), VIA(4)) are arranged to be interleaved with the set of first pads (PAD1) along at least one third predetermined direction to shrink the memory signal via region (702).

5. The method of claim 2, wherein a size of the memory signal via region (702) is equal to a third predetermined multiple of the first pitch multiplied by a fourth predetermined multiple of the second pitch.

6. The method of claim 5, wherein the third predetermined multiple is greater than or equal to the first predetermined multiple plus one, and the fourth predetermined multiple is greater than or equal to the second predetermined multiple plus one.

7. The method of claim 1, wherein vias near a boundary of the memory signal via region (702) among the multiple vias (VIA(0), VIA(1), VIA(2), VIA(3), VIA(4)) are arranged to surround grid lines (700) formed by respective centers of the set of first pads (PAD1).

8. The method of claim 1, wherein a first portion of second pads among the set of second pads (PAD2) are positioned within the memory signal via region (702), and a second portion of second pads among the set of second pads (PAD2) are positioned outside the memory signal via region (702); and the multiple vias (VIA(0), VIA(1), VIA(2), VIA(3), VIA(4)) extend through the two sides of the PCB (100, 200) to allow a portion of memory signals among the set of predetermined memory signals to be transmitted between the control circuit (110) and the memory (120), and between inside and outside of the memory signal via region (702), by a portion of first pads among the set of first pads (PAD1), a portion of vias among the multiple vias (VIA(0), VIA(1), VIA(2), VIA(3), VIA(4)), and the second portion of second pads among the set of second pads (PAD2).

9. A control circuit (110) whose package (#1) is implemented according to the method of claim 1, wherein the package (#1) of the control circuit (110) comprises:
the set of pads (111, 112, PAD0), positioned within a first sub-region (801) of the board-side region (211, 800), configured to act as said control-side memory signal pads, wherein the first sub-region (801) of the board-side region (211, 800) is used as a first ball arrangement range of said control-side memory signal pads on the board-side region (211, 800); and
the multiple other pads (PAD0), positioned within a second sub-region (802) of the board-side region (211, 800), configured to act as said other-purpose pads, wherein the second sub-region (802) does not overlap with the first sub-region (801).

10. A printed circuit board (PCB) (100, 200) whose multiple pads (PAD1, PAD2) are implemented according to the method of claim 1, wherein the multiple pads (PAD1, PAD2) of the PCB (100, 200) comprise:
the set of first pads (PAD1), positioned within a first sub-region of the first installation region (300), the first sub-region of the first installation region (300) corresponding to a first ball arrangement range of said control-side memory signal pads on the board-side region (211, 800); and
the set of remaining pads (PAD1), positioned within a second sub-region of the first installation region (300), wherein the second sub-region of the first installation region (300) does not overlap with the first sub-region of the first installation region (300).
